# EUROPEAN PATENT APPLICATION

(11) **EP 4 379 822 A1**
(43) Date of publication of application: **05.06.2024**
(21) Application number: 22855695.7
(22) Date of filing: 03.03.2022
(51) Int. Cl.: H01L 33/38, H01L 33/40, H01S 5/042, H01S 5/183

(54) **CONDUCTIVE LAYER STRUCTURE AND LIGHT-EMITTING DEVICE**

(30) Priority: 10.08.2021 JP 2021130944
(71) Applicant: Sony Semiconductor Solutions Corporation, Atsugi-shi, Kanagawa 243-0014 (JP)
(72) Inventor: AOYAGI, Hidekazu, Kikuchi-gun, Kumamoto 869-1102 (JP); SUZUKI, Shinichi, Kikuchi-gun, Kumamoto 869-1102 (JP); TANNO, Katsuharu, Kikuchi-gun, Kumamoto 869-1102 (JP); SAITOU, Kazunari, Atsugi-shi, Kanagawa 243-0014 (JP); TANAKA, Takayuki, Kikuchi-gun, Kumamoto 869-1102 (JP); YASHIMA, Kiyotaka, Kikuchi-gun, Kumamoto 869-1102 (JP); SUGIYAMA, Takashi, Kikuchi-gun, Kumamoto 869-1102 (JP); MITOMO, Jugo, Kikuchi-gun, Kumamoto 869-1102 (JP); FUJII, Kentaro, Kikuchi-gun, Kumamoto 869-1102 (JP); NAKATA, Hidehiko, Kikuchi-gun, Kumamoto 869-1102 (JP)
(74) Representative: D Young & Co LLP
(86) International application number: PCT/JP2022/009158
(87) International publication number: WO 2023/017629

(57) **Abstract**

A conductive layer structure includes a first conductive layer and a second conductive layer that is electrically coupled to the first conductive layer with an adhesion layer interposed. The adhesion layer has conductivity and has a higher adhesiveness to each of the first conductive layer and the second conductive layer than adhesiveness between the first conductive layer and the second conductive layer. The second conductive layer is less likely to deteriorate than the adhesion layer, and covers an end surface and an upper surface of the adhesion layer while covering a portion of the first conductive layer.

## Description

### Technical Field

The present disclosure relates to a conductive layer structure, and to a light emitting device.

### Background Art

PTL 1 discloses a semiconductor device including a capacitance element. The capacitance element includes a lower electrode, a dielectric film on the lower electrode, and an upper electrode on the dielectric film. An insulating film is formed on the upper electrode with an adhesion layer interposed, and a contact hole is formed to penetrate through the adhesion layer and the insulating film in a thickness direction. As the insulating film, for example, a silicon oxide film is used, and the adhesion layer includes Ti, for example. To the upper electrode, metal wiring is coupled via the contact hole.

### Citation List

### Patent Literature

PTL 1: Japanese Unexamined Patent Application Publication No. 2003-324157

### Summary of the Invention

Meanwhile, when exposed to a high temperature and high humidity environment, Ti included in the adhesion layer deteriorates and becomes for example, oxidized. A Ti oxide is a high-resistance material, increasing resistance of a current path. For example, in an electrode configuration or wiring configuration that supplies an electric current to a light emitting device, an increase in resistance is likely to cause an increase in drive voltage or a luminescence failure. For this reason, it is desired to effectively suppress or prevent the increase in the resistance of the current path due to an employment of the adhesion layer in a conductive layer structure including an electrode configuration and a wiring configuration.

A conductive layer structure according to a first embodiment of the present disclosure includes a first conductive layer and a second conductive layer that is electrically coupled to the first conductive layer with an adhesion layer interposed. The adhesion layer has conductivity and has a higher adhesiveness to each of the first conductive layer and the second conductive layer than adhesiveness between the first conductive layer and the second conductive layer. The second conductive layer is less likely to deteriorate than the adhesion layer, and covers an end surface and an upper surface of the adhesion layer while covering a portion of the first conductive layer.

A conductive layer structure according to a second embodiment of the present disclosure includes a first conductive layer, a third conductive layer that is electrically coupled to the first conductive layer with an adhesion layer interposed, and a second conductive layer that is electrically coupled to the third conductive layer. The adhesion layer has conductivity and has a higher adhesiveness to each of the first conductive layer and the third conductive layer than adhesiveness between the first conductive layer and the third conductive layer. The second conductive layer is less likely to deteriorate than the adhesion layer, covers an end and an upper surface of the adhesion layer while covering a portion of the first conductive layer.

A conductive layer structure according to a third embodiment of the present disclosure includes a first conductive layer, a fourth conductive layer that is formed on the first conductive layer with an insulator interposed, and a second conductive layer having one end coupled to the first conductive layer with an adhesion layer interposed, a middle portion laminated on an insulator, and another end coupled to the fourth conductive layer with the adhesion layer interposed in between. The adhesion layer has conductivity, and has a higher adhesiveness to each of the first, the second, and the fourth conductive layers than adhesiveness between the first conductive layer and the second conductive layer or adhesiveness between the fourth conductive layer and the second conductive layer. The second conductive layer is less likely to deteriorate than the adhesion layer, and covers an end surface and an upper surface of the adhesion layer while covering a portion of the first conductive layer and a portion of the fourth conductive layer.

A light emitting device according to a fourth embodiment of the present disclosure includes a light emitting element and a conductive layer structure that is formed in the light emitting element and supplies an electric current to the light emitting element. The conductive layer structure has a first conductive layer and a second conductive layer that is electrically coupled to the first conductive layer with an adhesion layer interposed. The adhesion layer has conductivity, and has a higher adhesiveness to each of the first conductive layer and the second conductive layer than adhesiveness between the first conductive layer and the second conductive layer. The second conductive layer is less likely to deteriorate than the adhesion layer, and covers an end surface and an upper surface of the adhesion layer while covering a portion of the first conductive layer.

### Brief Description of Drawings

[FIG. 1] FIG. 1 is a longitudinal sectional view of a conductive layer structure and a light emitting device including the conductive layer structure according to a first embodiment of the present disclosure.
[FIG. 2A] FIG. 2A is a first process planar view describing a method of manufacturing the conductive layer structure according to the first embodiment.
[FIG. 2B] FIG. 2B is a first process cross-sectional view taken along section line A-A illustrated in FIG. 2A.
[FIG. 2C] FIG. 2C is a first process cross-sectional view taken along section line B-B illustrated in FIG. 2A.
[FIG. 3A] FIG. 3A is a second process planar view describing a method of manufacturing the conductive layer structure according to the first embodiment.
[FIG. 3B] FIG. 3B a second process cross-sectional view taken along section line A-A illustrated in FIG. 3A.
[FIG. 3C] FIG. 3C is a second process cross-sectional view taken along section line B-B illustrated in FIG. 3A.
[FIG. 4A] FIG. 4A is a third process planar view describing a method of manufacturing the conductive layer structure according to the first embodiment.
[FIG. 4B] FIG. 4B is a third process cross-sectional view taken along section line A-A illustrated in FIG. 4A.
[FIG. 4C] FIG. 4C is a third process cross-sectional view taken along section line B-B illustrated in FIG. 4A.
[FIG. 5] FIG. 5 is a longitudinal sectional view of a conductive layer structure and a light emitting device including the conductive layer structure according to a second embodiment of the present disclosure.
[FIG. 6] FIG. 6 is a longitudinal sectional view of a conductive layer structure and a light emitting device including the conductive layer structure according to a third embodiment of the present disclosure.
[FIG. 7A] FIG. 7A is a first process planar view describing a method of manufacturing the conductive layer structure according to the third embodiment.
[FIG. 7B] FIG. 7B is a first process cross-sectional view taken along section line C-C illustrated in FIG. 7A.
[FIG. 7C] FIG. 7C is a first process cross-sectional view taken along section line D-D illustrated in FIG. 7A.
[FIG. 8A] FIG. 8A is a second process planar view describing a method of manufacturing the conductive layer structure according to the third embodiment.
[FIG. 8B] FIG. 8B is a second process cross-sectional view taken along section line C-C illustrated in FIG. 8A.
[FIG. 8C] FIG. 8 C is a second process cross-sectional view taken along section line D-D illustrated in FIG. 8A.
[FIG. 9A] FIG. 9A is a third process planar view describing the method of manufacturing the conductive layer structure according to the third embodiment.
[FIG. 9B] FIG. 9B is a third process cross-sectional view taken along section line C-C illustrated in FIG. 9A.
[FIG. 9C] FIG. 9C is a third process cross-sectional view taken along section line D-D illustrated in FIG. 9A.
[FIG. 10] FIG. 10 is a longitudinal sectional view of a conductive layer structure and a light emitting device including the conductive layer structure according to a fourth embodiment of the present disclosure.

### Modes for Carrying Out the Invention

In the following, embodiments of the present disclosure will be described in detail with reference to the drawings. It is to be noted that the description will be given in the following order.

### 1. First Embodiment

A first embodiment is a first example in which the present technique is applied to a conductive layer structure and a light emitting device including the conductive layer structure. Here, the light emitting device is a vertical cavity surface emitting laser (VCSEL: Vertical Cavity Surface Emitting Laser) as an example. In addition, in the first example, a method of manufacturing the conductive layer structure will also be described in particular.

### 2. Second Embodiment

A second embodiment describes a second example in which a configuration of the conductive layer structure is changed in the conductive layer structure and the light emitting device according to the first embodiment.

### 3. Third Embodiment

A third embodiment describes a third example in which a configuration of the conductive layer structure is changed in the conductive layer structure and the light emitting device according to the first embodiment.

### 4. Fourth Embodiment

A fourth embodiment is a fourth example in which the present technique is applied to a conductive layer structure and a light emitting device including the conductive layer structure. Here, the light emitting device is a light emitting diode (LED: Light Emitting Diode) as an example.

### 5. Other Embodiment

### <1. First Embodiment>

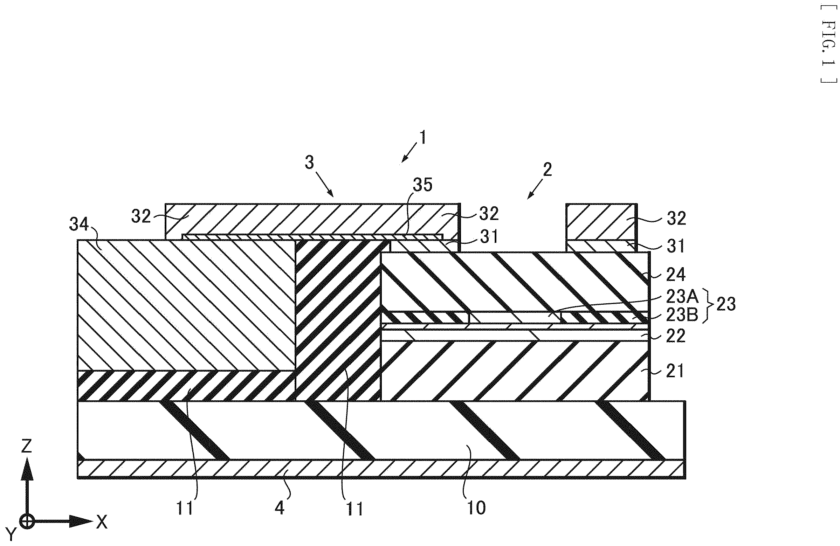

A conductive layer structure 3 and a light emitting device 1 according to a first embodiment of the present disclosure will be described with reference to FIG. 1, FIGs. 2A to 2C, FIGs. 3A to 3C, and FIGs. 4A to 4C.

Here, an arrow X direction, which is illustrated in figures as appropriate, indicates one planar direction of the conductive layer structure 3 and the light emitting device 1 that are disposed on a planar surface for a descriptive purpose. An arrow Y direction indicates another planar direction orthogonal to the arrow X direction. In addition, an arrow Z direction indicates an upper direction orthogonal to the arrow X direction and the arrow Y direction. In other words, the arrow X, Y, and Z directions just correspond to X, Y, and Z axes of a three-dimensional coordinate system, respectively.

It is to be noted that these directions are each illustrated to help understanding of the description, and do not limit a direction in the present technique.

### [Configuration of Conductive Layer Structure 3 and Light Emitting Device 1]

### (1) Overall Schematic Configuration of Conductive Layer Structure 3 and Light Emitting Device 1

FIG. 1 illustrates a longitudinal sectional configuration of an example of the conductive layer structure 3 and the light emitting device 1 according to the first embodiment of the present disclosure.

The light emitting device 1 according to the first embodiment includes a light emitting element 2. Furthermore, the light emitting device 1 includes the conductive layer structure 3.

The light emitting element 2 is laminated on a substrate 10 as a base in a region a lateral surface of which is surrounded by an insulator 11. In the first embodiment, the light emitting element 2 is a VCSEL as a surface emitting laser. The light emitting element 2 includes a first reflection layer 21, an emission layer 22, a current constriction layer 23, and a second reflection layer 24, each as a major component.

For the light emitting element 2, a plurality of light emitting elements 2 is arranged in each of the arrow X direction and the arrow Y direction with the insulator 11 interposed.

On the other hand, the conductive layer structure 3 includes a first conductive layer 31 and a second conductive layer 32 that is electrically coupled to the first conductive layer 31 with an adhesion layer 35 interposed. The conductive layer structure 3 further includes a fourth conductive layer 34 that is formed with the insulator 11 interposed in the first conductive layer 31. The second conductive layer 32 has one end coupled to the first conductive layer 31 and has another end coupled to the fourth conductive layer 34 with the adhesion layer 35 interposed. A middle portion of the second conductive layer 32 is laminated on the insulator 11 with the adhesion layer 35 interposed.

In the following, components of each of the conductive layer structure 3 and the light emitting device 1 will be described in detail.

### (2) Configuration of Substrate 10

The substrate 10 is used as an epitaxial growth substrate. For the substrate 10, for example, n-type GaAs is used. In the first embodiment, the "first conductivity type" is described as "n-type." As an n-type impurity, S is used.

It is to be noted that a buffer layer may be laminated on the substrate 10. When the buffer layer is laminated, it is possible to configure a terrace and step structure having high smoothness.

On an opposite (back surface) side of the substrate 10 to a side on which the light emitting element is laminated, a contact layer 4 is provided. The contact layer 4 supplies an electric current to the light emitting elements 2.

### (3) Configuration of Light Emitting Element 2

### (3-1) Configuration of First Reflection Layer 21

The first reflection layer 21 is laminated directly on the substrate 10, or laminated on the substrate 10 with a buffer layer interposed, an illustration of which is omitted. Here, the first reflection layer 21 is a semiconductor DBR (Distributed Bragg Reflector). In other words, the first reflection layer 21 has a configuration in which a plurality of semiconductor layers having two or more types with different refractive indices is alternately laminated. For example, in the first reflection layer 21, a plurality of semiconductor layers each including n-type AlGaAs or n-type GaAs is alternately laminated.

It is to be noted that the first reflection layer 21 may include a dielectric DBR, for example.

### (3-2) Configuration of Light Emitting Layer 22

The light emitting layer 22 is laminated on the first reflection layer 21. The light emitting layer 22 has a configuration in which a plurality of layers including a barrier layer and a quantum well layer is alternately laminated.

For the barrier layer, for example, non-doped AlGaInAs is used.

The quantum well layer includes at least one element selected from Al, Ga, and In among group III elements, and at least one element selected from As, P, and N among group V elements. Here, for example, the quantum well layer includes non-doped AlGaInAs as a main component.

In addition, a quantum wire or quantum dot may be used instead of the quantum well layer. Furthermore, in the first embodiment, the light emitting layer 22 may be configured as a strain-compensation quantum well.

### (3-3) Configuration of Current Constriction Layer 23

A current constriction layer 23 is laminated on the light emitting layer 22. The current constriction layer 23 includes a current passage region 23A that is formed in a middle portion and a current constriction region 23B that is formed in a periphery of the current passage region 23A. For example, the current passage region 23A has a circular shape when viewed from the arrow Z direction (hereinafter simply referred to as "in planar view"). For example, the current constriction region 23B includes an oxide or an ion-implanted region.

### (3-4) Configuration of Second Reflection Layer 24

A second reflection layer 24 is laminated on the current constriction layer 23. Here, the second reflection layer 24 is a semiconductor DBR. In other words, as with the first reflection layer 21, the second reflection layer 24 has a configuration in which a plurality of semiconductor layers having two or more types with different refractive indices is alternately laminated. For example, the second reflection layer 24 has a configuration in which a plurality of semiconductor layers each including p-type AlGaAs or p-type GaAs as the second conductivity type is alternately laminated.

It is to be noted that the second reflection layer 24 may include a dielectric DBR, for example.

### (4) Configuration of Conductive Layer Structure 3

### (4-1) Configuration of First Conductive Layer 31

The first conductive layer 31 is laminated on the second reflection layer 24 of the light emitting element 2 and formed along a periphery of the second reflection layer 24. Here, in planar view, the first conductive layer 31 is formed in a shape of a ring with a missing portion. The first conductive layer 31 is formed as an electrode of the light emitting element 2 or a contact layer.

For example, the first conductive layer 31 includes a multilayer film in which Au, Pt, and Ti are each sequentially laminated. For example, Au is formed to have a thickness of 50 nm or more and 500 nm or less. For example, Pt is formed to have a thickness of 10 nm or more and 100 nm or less. For example, Ti is formed to have a thickness of 10 nm or more and 100 nm or less.

It is to be noted that for the first conductive layer 31, it is possible to include at least one material selected from Au, Al, Cu, Ag, Rh, W, Mo, Ni, Pd, ITO, ITiO, ZnO, and AuGe. Au, Al, Cu, Ag, Rh, W, Mo, Ni, and Pd are each a metal material. ITO, ITiO, and ZnO are each a transparent metal material. AuGe is an alloy material. It is possible to use these materials as a monolayer film or as a multilayer film.

### (4-2) Configuration of Fourth Conductive Layer 34

The fourth conductive layer 34 is formed on the substrate 10 in an outer periphery of the light emitting element 2 with the insulator 11 interposed. The fourth conductive layer 34 is configured as wiring that supplies an electric current to the light emitting element 2.

The fourth conductive layer 34 includes Au, for example. For example, Au is formed to have a thickness of 0.5 µm or more and 5 µm or less.

In addition, the fourth conductive layer 34 may include a material similar to the material given as an example in the first conductive layer 31.

### (4-3) Composition of Adhesive Layer 35

The adhesion layer 35 is formed from the first conductive layer 31 to the fourth conductive layer 34. In other words, the adhesion layer 35 has one end laminated on the first conductive layer 31, and has another end laminated on the fourth conductive layer 34. A middle portion of the adhesion layer 35 is formed on the insulator 11.

Here, in planar view, a position of an end surface of the adhesion layer 35, excluding a connection point between the first conductive layer 31 and the fourth conductive layer 34, is set inside a position of an end surface of the first conductive layer 31. Similarly, the position of the end surface of the adhesion layer 35 is set inside a position of an end surface of the fourth conductive layer 34.

The adhesion layer 35 has a higher adhesiveness (or adhesion) to each of the first conductive layer 31, the second conductive layer 32, and the fourth conductive layer 34 than adhesiveness between the first conductive layer and the second conductive layer 32 and adhesiveness between the fourth conductive layer 34 and the second conductive layer 32. For the adhesion layer 35, Ti is used, for example. For example, Ti is formed to have a thickness of 10 nm or more and 100 nm or less.

It is to be noted that for the adhesion layer 35, it is possible to include, other than Ti as described above, at least one material selected from Ni, Al, Pd, Mg, Si, Cu, Ag, and TiW.

### (4-4) Composition of Second Conductive Layer 32

The second conductive layer 32 is configured as an electrode on each of the first conductive layer 31 and the fourth conductive layer 34. Furthermore, the second conductive layer 32 is configured as bridge wiring that electrically couples two layers from the first conductive layer 31 to the fourth conductive layer 34. The second conductive layer 32 is formed in a state of covering an end surface and an upper surface of the adhesion layer 35. Compared to the adhesion layer 35, the second conductive layer 32 includes a material that is less likely to deteriorate even when exposed to a high temperature and high humidity environment. For example, the second conductive layer 32 includes a material that is less likely to be oxidated or nitrided than the adhesion layer 35. Furthermore, a portion of the second conductive layer 32 also covers the first conductive layer 31 and is also electrically coupled to the first conductive layer 31. Then, another portion of the second conductive layer 32 covers the fourth conductive layer 34 likewise and is also electrically coupled to the fourth conductive layer 34. The second conductive layer 32 is configured to cover the adhesion layer 35 while covering a portion from the adhesion layer 35 to each of the first conductive layer 31 and the fourth conductive layer 34. As a result, an entry route to an interface between the adhesion layer 35 and the first conductive layer 31 and an entry route to an interface between the adhesion layer 35 and the fourth conductive layer 34 are each blocked by the second conductive layer 32.

For example, the second conductive layer 32 includes Au. Au is formed using an electrolytic plating method or an electroless plating method. The second conductive layer 32 is formed to have a greater thickness than the adhesion layer 35, for example, to a thickness of 0.5 µm or more and 3.0 µm or less.

For the second conductive layer 32, it is possible to include, other than Au as described above, at least one material selected from Cu, Ni, Co, Sn, Pt, Ag, Pb, Zn, and Pd. It is possible to include all of these materials by a plating method.

### [Method of Manufacturing Conductive Layer Structure 3]

Here, a description of a method of manufacturing the light emitting element 2 will be omitted, and only the method of manufacturing the conductive layer structure 3 will be briefly described.

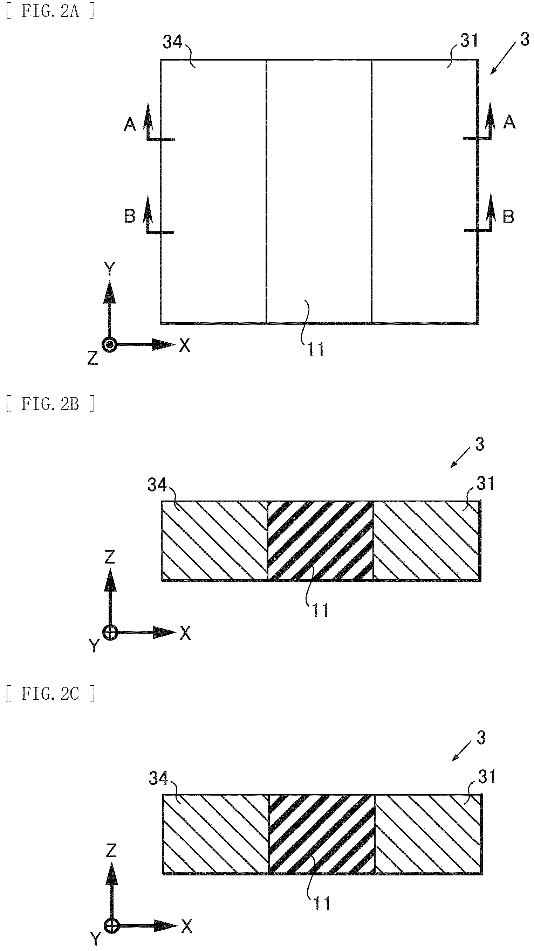

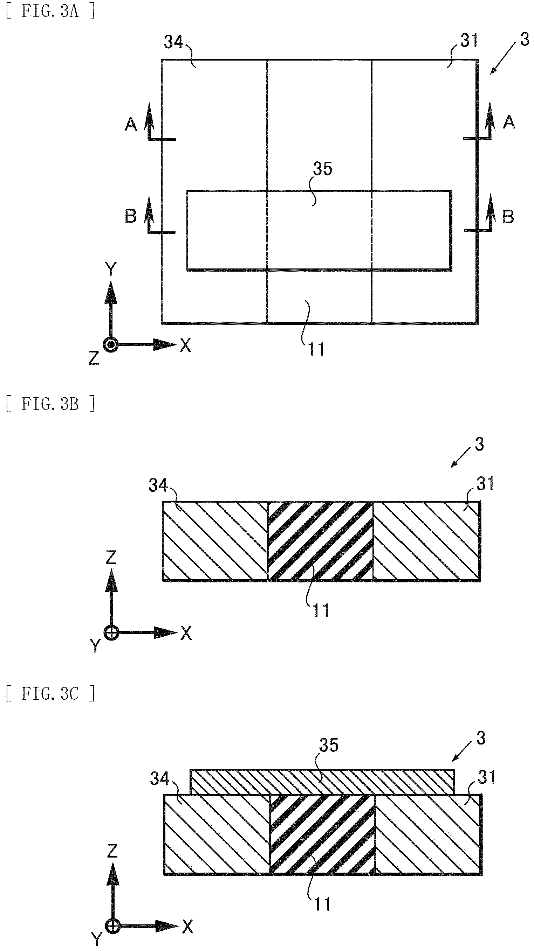

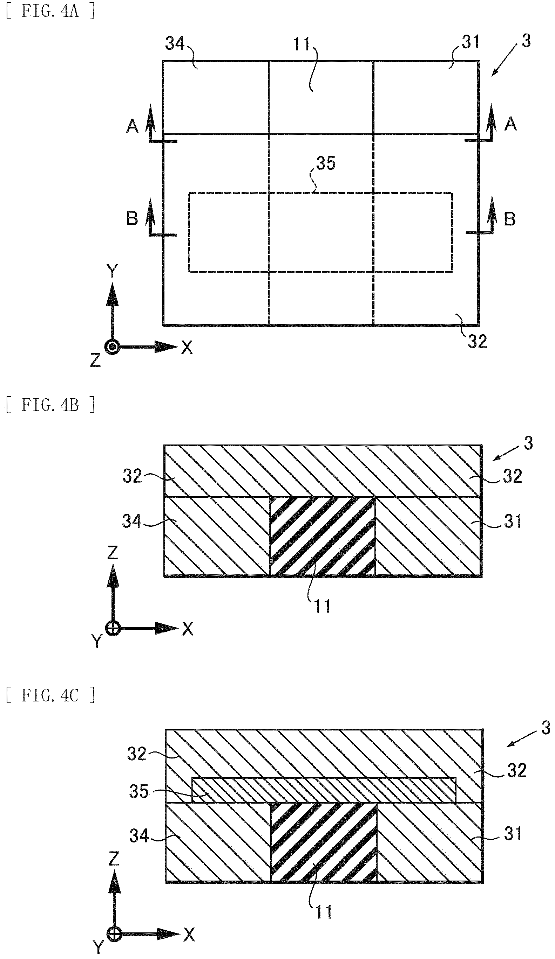

FIGs. 2A, 3A, and 4A each illustrate a planar surface in each process, which describes the method of manufacturing the conductive layer structure 3. FIG. 2B illustrates a process cross section of the conductive layer structure 3 taken along section line A-A illustrated in FIG. 2A, and FIG. 2C illustrates a process cross section of the conductive layer structure 3 taken along section line B-B illustrated in FIG. 2A. FIG. 3B illustrates a process cross section of the conductive layer structure 3 taken along section line A-A illustrated in FIG. 3A, and FIG. 3C illustrates a process cross section of the conductive layer structure 3 take along section line B-B illustrated in FIG. 3A. Then, FIG. 4B illustrates a process cross section of the conductive layer structure 3 taken along section line A-A illustrated in FIG. 4A, and FIG. 4C illustrates a process cross section of the conductive layer structure 3 taken along section line B-B illustrated in FIG. 4A.

After the light emitting element 2 is formed on the substrate 10 (see FIG. 1), each of the first conductive layer 31 and the fourth conductive layer 34 is formed as illustrated in FIGs. 2A to 2C. The first conductive layer 31 is formed on the second reflection layer 24 of the light emitting element 2. For example, the first conductive layer 31 is formed by evaporation, sputtering, plating, or the like. The fourth conductive layer 34 is formed at a position separated from the light emitting element 2 with the insulator 11 interposed with respect to the first conductive layer 31. For example, the fourth conductive layer 34 is formed by evaporation, sputtering, plating, or the like.

Next, as illustrated in FIGs. 3A to 3C, the adhesion layer 35 is formed on a portion from the first conductive layer 31 to the fourth conductive layer 34. For example, the adhesion layer 35 is formed using sputtering or the like.

Next, as illustrated in FIG. 1 and FIGs. 4A to 4C described earlier, the second conductive layer 32 is formed in a state of covering the adhesion layer 35 including the end surface and upper surface of the adhesion layer 35. A portion of the second conductive layer 32 is also formed on the first conductive layer 31, and the second conductive layer 32 is electrically coupled to the first conductive layer 31. Likewise, another portion of the second conductive layer 32 is also formed on the fourth conductive layer 34, and the second conductive layer 32 is electrically coupled to the fourth conductive layer 34. In other words, the second conductive layer 32 is formed as bridge wiring that couples the first conductive layer 31 and the fourth conductive layer 34.

The second conductive layer 32 is formed using an electrolytic plating method or an electroless plating method. This forms the second conductive layer 32 selectively on an exposed surface of each of the first conductive layer 31, the fourth conductive layer 34, and the adhesion layer 35. Accordingly, in forming the second conductive layer 32, it is not necessary to use photolithography and etching technologies.

### [Workings and Effects]

As illustrated in FIG. 1, the conductive layer structure 3 according to the first embodiment includes the first conductive layer 31 and the second conductive layer 32. The second conductive layer 32 is electrically coupled to the first conductive layer 31 with the adhesion layer 35 interposed. The adhesion layer 35 has conductivity and has a higher adhesiveness to each of the first conductive layer 31 and the second conductive layer 32 than adhesiveness between the first conductive layer 31 and the second conductive layer 32. The second conductive layer 32 is less likely to deteriorate than the adhesion layer 35, and couples a portion of the adhesion layer 35 to the first conductive layer 31 in a state of covering the adhesion layer 35 including an end surface thereof.

Here, the adhesion layer 35 is covered by the second conductive layer 32 in a state where the adhesiveness between the first conductive layer 31 and the second conductive layer 32 is increased by the adhesion layer 35. In other words, even when exposed to a high temperature and high humidity environment, a route for oxygen or the like to enter the adhesion layer 35 is blocked. This makes it possible to effectively suppress or prevent an increase in resistance of a current path due to a deterioration of the adhesion layer 35.

In addition, a portion of the second conductive layer 32 is directly and electrically coupled to the first conductive layer 31, thus making it possible to further reduce the resistance of the current path from the first conductive layer 31 to the second conductive layer 32.

In addition, in the conductive layer structure 3 as illustrated in FIG. 1, the second conductive layer 32 has a greater thickness than the adhesion layer 35. This increases an overall thickness of the conductive layer structure 3, making it possible to further reduce the resistance of the current path.

Furthermore, in the conductive layer structure 3 and the method of manufacturing the conductive layer structure 3, the second conductive layer 32 is a plating layer formed by an electrolytic plating method or an electroless plating method, as illustrated in FIG. 1, FIGs. 2A to 2C, and FIGs. 3A to 3C. The second conductive layer 32 covers the adhesion layer 35 including the end and upper surfaces thereof, and is further formed on a surface of the first conductive layer 31 exposed from the adhesion layer 35, to be formed from the adhesion layer 35 to the first conductive layer 31.

This removes an entry route for oxygen or the like not only from the exposed surface of the adhesion layer 35 but also from the interface between the first conductive layer 31 and the adhesion layer 35. Accordingly, it is possible to effectively suppress or prevent a deterioration of the adhesion layer 35, making it possible to suppress or prevent more effectively an increase in resistance of the current path caused by the deterioration of the adhesion layer 35.

In addition, a portion of the second conductive layer 32 is directly and electrically coupled to the first conductive layer 31, thus making it possible to further reduce the resistance of the current path from the first conductive layer 31 to the second conductive layer 32.

As illustrated in FIG. 1, the conductive layer structure 3 according to the first embodiment includes the first conductive layer 31, the fourth conductive layer 34, and the second conductive layer 32. The fourth conductive layer 34 is formed with the insulator 11 interposed in the first conductive layer 31. The second conductive layer 32 has one end coupled to the first conductive layer 31 with the adhesion layer 35 interposed, has a middle portion formed at the insulator 11, and has another end coupled to the fourth conductive layer 34 with the adhesion layer 35 interposed. The adhesion layer 35 has conductivity and has a higher adhesiveness to each of the first conductive layer 31, the second conductive layer 32, and the fourth conductive layer 34 than adhesiveness between the first conductive layer 31 and the second conductive layer 32 or adhesiveness between the fourth conductive layer 34 and the second conductive layer 32. Then, the second conductive layer 32 is less likely to deteriorate than the adhesion layer 35, and couples a portion of the adhesion layer 35 to the first conductive layer 31 while coupling another portion of the adhesion layer 35 to the fourth conductive layer 34 in a state of covering the adhesion layer 35 including an end surface and an upper surface thereof.

Here, the adhesion layer 35 is covered by the second conductive layer 32 in a state where the adhesiveness between the first conductive layer 31 and the second conductive layer 32 and the adhesiveness between the fourth conductive layer 34 and the second conductive layer 32 are increased by the adhesion layer 35. In other words, even when exposed to a high temperature and high humidity environment, a route for oxygen or the like to enter the adhesion layer 35 is blocked. This makes it possible to effectively suppress or prevent an increase in resistance of a current path due to a deterioration of the adhesion layer 35.

In addition, a portion of the second conductive layer 32 is directly and electrically coupled to each of the first conductive layer 31 and the fourth conductive layer 34, thus making it possible to further reduce the resistance of the current path from the first conductive layer 31 to the fourth conductive layer 34 through the second conductive layer 32.

As illustrated in FIG. 1, the light emitting device 1 according to the first embodiment includes the light emitting element 2 and the conductive layer structure 3. The conductive layer structure 3 is coupled to the light emitting element 2 and supplies an electric current to the light emitting element 2. Then, the conductive layer structure 3 includes the first conductive layer 31 and the second conductive layer 32. The second conductive layer 32 is electrically coupled to the first conductive layer 31 with the adhesion layer 35 interposed. The adhesion layer 35 has conductivity and has a higher adhesiveness to each of the first conductive layer 31 and the second conductive layer 32 than adhesiveness between the first conductive layer 31 and the second conductive layer 32. The second conductive layer 32 is less likely to deteriorate than the adhesion layer 35, and couples a portion of the adhesion layer 35 to the first conductive layer 31 in a state of covering the adhesion layer 35 including an end surface and an upper surface thereof.

Here, the adhesion layer 35 is covered by the second conductive layer 32 in a state where the adhesiveness between the first conductive layer 31 and the second conductive layer 32 is increased by the adhesion layer 35. In other words, even when exposed to a high temperature and high humidity environment, a route for oxygen or the like to enter the adhesion layer 35 is blocked. This makes it possible to effectively suppress or prevent an increase in resistance of a current path due to a deterioration of the adhesion layer 35.

In addition, a portion of the second conductive layer 32 is directly and electrically coupled to the first conductive layer 31, thus making it possible to further reduce the resistance of the current path from the first conductive layer 31 to the second conductive layer 32.

In the light emitting device 1 configured in this manner, the current path in the conductive layer structure 3 has a small resistance, thus making it possible to effectively suppress or prevent an increase in drive voltage and a luminescence failure.

### <2. Second Embodiment>

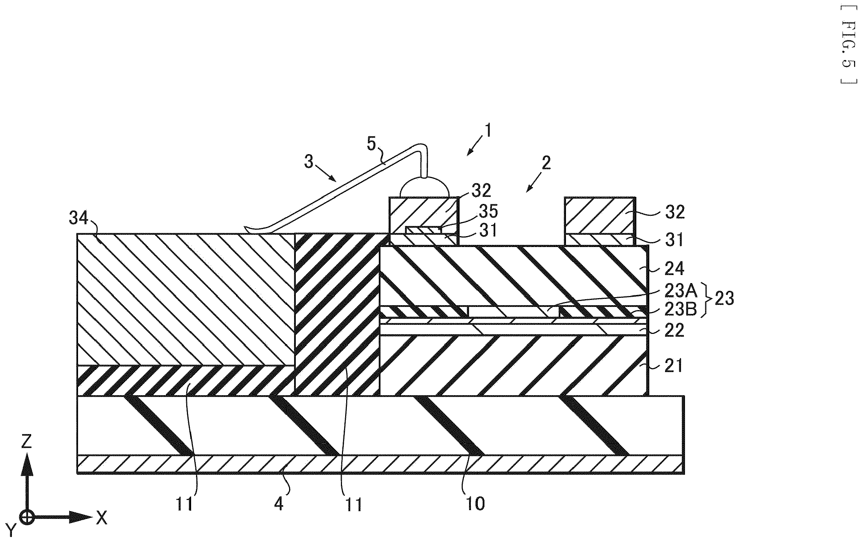

A conductive layer structure 3 and a light emitting device 1 according to a second embodiment of the present disclosure will be described with reference to FIG. 5. It is to be noted that in the second and subsequent embodiments, the same reference numerals will be given to the same components or substantially the same components as those of the conductive layer structure 3 and the light emitting device 1 according to the first embodiment, and the overlapping description thereof will be omitted.

### [Configuration of Conductive Layer Structure 3 and Light Emitting Device 1]

FIG. 5 illustrates a longitudinal sectional configuration of an example of the conductive layer structure 3 and the light emitting device 1 according to the second embodiment.

The light emitting device 1 according to the second embodiment, as with the light emitting device 1 according to the first embodiment, includes the conductive layer structure 3. The conductive layer structure 3 includes a first conductive layer 31 that is formed on a second reflection layer 24 of the light emitting element 2, and a second conductive layer 32 that is electrically coupled to the first conductive layer 31 with an adhesion layer 35 interposed in the first conductive later 31. In the conductive layer structure 3, a fourth conductive layer 34 is formed around an outer periphery of the light emitting element 2.

Then, the conductive layer structure 3 electrically couples the second conductive layer 32 and the fourth conductive layer 34 by wire 5. For example, the wire 5 is formed using an ultrasonic bonding method in combination with ultrasonic vibration. For example, Au wire is used for the wire 5.

It is to be noted that the wire 5 is not limited to Au wire. For example, for the wire 5, it is possible to use Al wire, Cu wire, or the like.

Components other than the above are the same as those of the conductive layer structure 3 and the light emitting device 1 according to the first embodiment.

### [Workings and Effects]

In the conductive layer structure 3 and the light emitting device 1 according to the second embodiment, it is possible to obtain the same workings and effects as those obtained by the conductive layer structure 3 and the light emitting device 1 according to the first embodiments.

### <3. Third Embodiment>

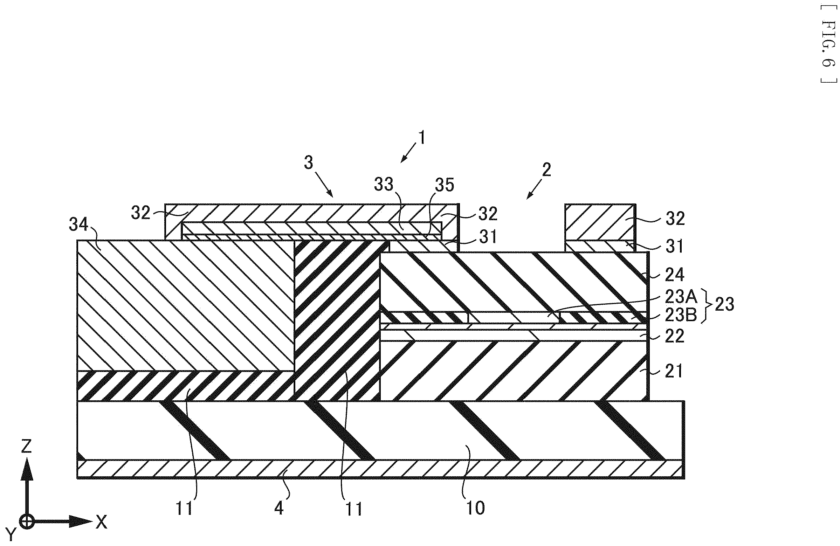

A conductive layer structure 3 and a light emitting device 1 according to a third embodiment of the present disclosure will be described with reference to FIG. 6, FIGs. 7A to 7C, FIGs. 8A to 8C, and FIGs. 9A to 9C.

### [Configuration of Conductive Layer Structure 3 and Light Emitting Device 1]

FIG. 6 illustrates a longitudinal sectional configuration of an example of the conductive layer structure 3 and the light emitting device 1 according to the third embodiment.

The light emitting device 1 according to the third embodiment, as with the light emitting device 1 according to the first embodiment, includes the conductive layer structure 3.

The conductive layer structure 3 includes a first conductive layer 31 that is formed on a second reflective layer 24 of the light emitting element 2, a third conductive layer 33 that is electrically coupled to the first conductive layer 31 with an adhesion layer 35 interposed, and a second conductive layer 32 that is electrically coupled to the third conductive layer 33. In the conductive layer structure 3, a fourth conductive layer 34 is formed around an outer periphery of the light emitting element 2. The fourth conductive layer 34 includes the third conductive layer 33 that is electrically coupled to the fourth conductive layer 34 with the adhesion layer 35 interposed, and the second conductive layer 32 that is electrically coupled to the third conductive layer 33.

In other words, the adhesion layer 35, the third conductive layer 33, and the second conductive layer 32 are formed from the first conductive layer 31 to the fourth conductive layer 34, to be included in bridge wiring.

In planar view, the third conductive layer 33 is formed in the same planar shape as a planar shape of the adhesion layer 35. In the manufacturing method, the adhesion layer 35 is patterned using the same mask formed by photolithography technology to pattern the third conductive layer 33.

For example, the third conductive layer 33 includes Au. For example, the third conductive layer 33 is formed to have a thickness of 10 nm or more and 100 nm or less. For the third conductive layer 33, other than Au, it is possible to use a material given as an example in the first conductive layer 31 described earlier.

The second conductive layer 32 is formed on a surface of the third conductive layer 33, and is also formed on the surface of each of the adhesion layer 35, the first conductive layer 31, and the fourth conductive layer 34 that are exposed from the third conductive layer 33.

Components other than the above are the same as those of the conductive layer structure 3 and the light emitting device 1 according to the first embodiment.

### [Method of Manufacturing Conductive Layer Structure 3]

Next, a method of manufacturing the conductive layer structure 3 according to the third embodiment will be briefly described.

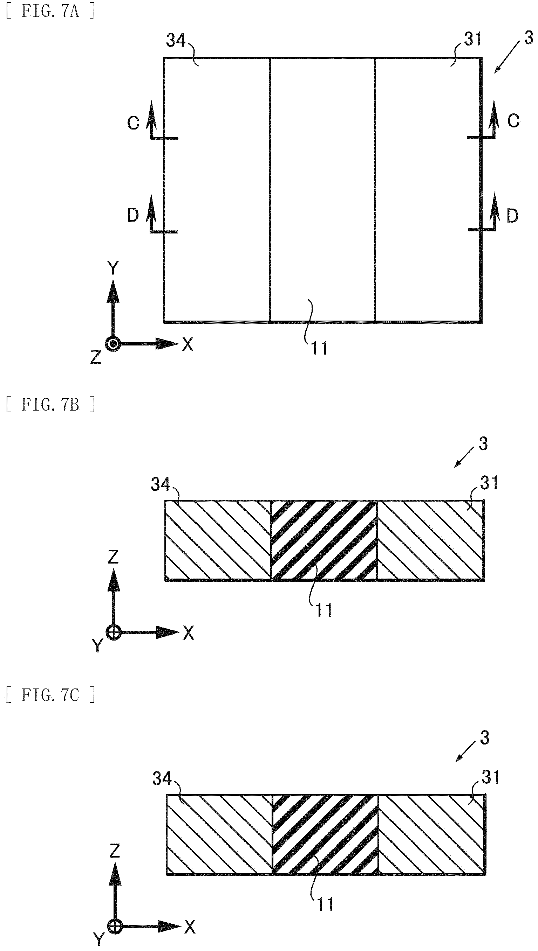

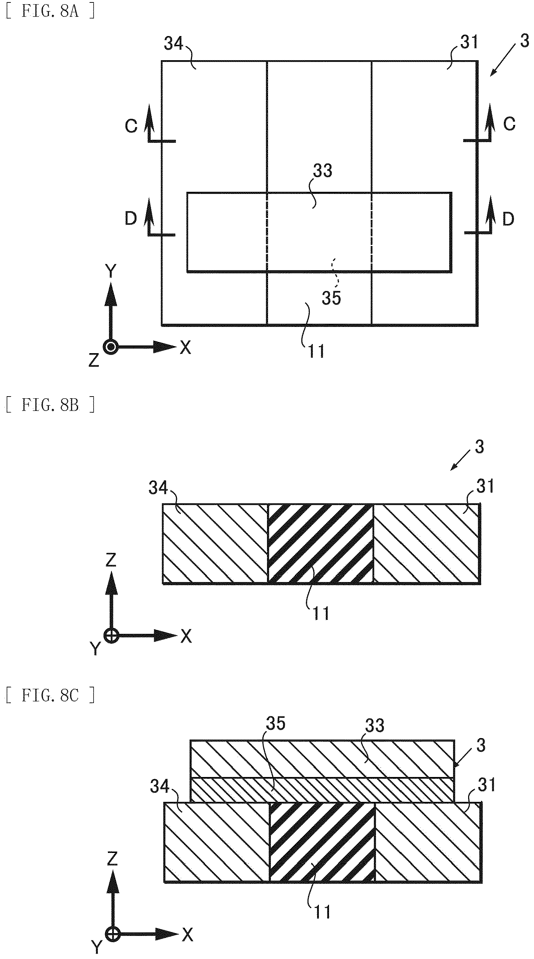

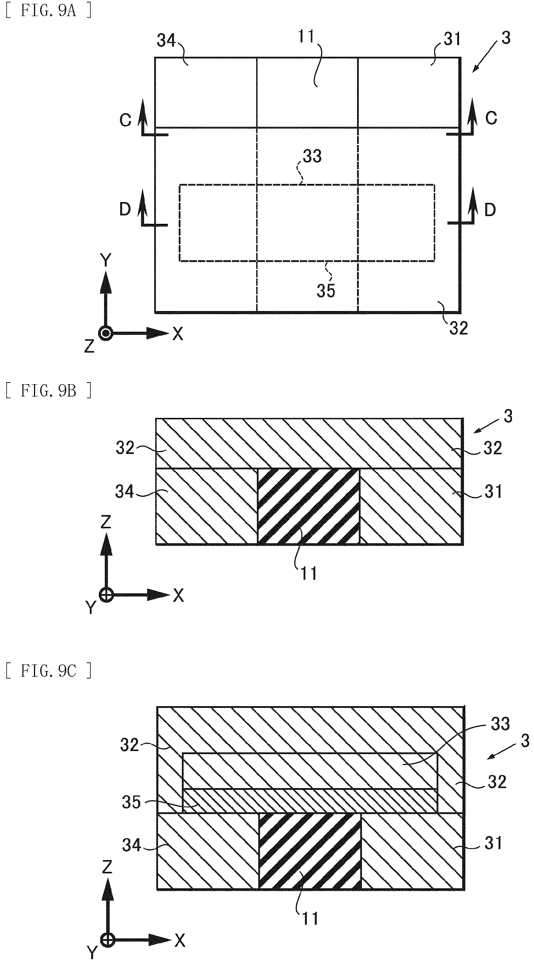

FIGs. 7A to 9A illustrate a planar surface in each process, which describes the method of manufacturing the conductive layer structure 3. FIG. 7B illustrates a process cross section of the conductive layer structure 3 taken along section line C-C illustrated in FIG. 7A, and FIG. 7C illustrates a process cross section of the conductive layer structure 3 taken along section line D-D illustrated in FIG. 7A. FIG. 8B illustrates a process cross section of the conductive layer structure 3 taken along section line C-C illustrated in FIG. 8A, and FIG. 8C illustrates a process cross section of the conductive layer structure 3 taken along section line D-D illustrated in FIG. 8A. FIG. 9B illustrates a process cross section of the conductive layer structure 3 taken along section line C-C illustrated in FIG. 9A, and FIG. 9C illustrates a process cross section of the conductive layer structure 3 taken along section line D-D illustrated in FIG. 9A.

After the light emitting element 2 is formed on the substrate 10 (see FIG. 6), each of the first conductive layer 31 and the fourth conductive layer 34 is formed as illustrated in FIGs 7A to 7C. The first conductive layer 31 is formed on the second reflective layer 24 of the light emitting element 2. The fourth conductive layer 34 is formed at a position separated from the light emitting element 2 with the insulator 11 interposed with respect to the first conductive layer 31.

Next, as illustrated in FIGs. 8A to 8C, the adhesion layer 35 and the third conductive layer 33 are formed on a portion from the first conductive layer 31 to the fourth conductive layer 34. The third conductive layer 33 is formed to be laminated on the adhesion layer 35. For example, the third conductive layer 33 is formed using evaporation, sputtering, or the like. The third conductive layer 33 and the adhesion layer 35 are patterned by etching technology, using the same mask formed by photolithography technology.

Next, as illustrated in FIG. 1 and FIGs. 9A to 9C described earlier, the second conductive layer 32 is formed in a state of covering the adhesion layer 35 and the third conductive layer 33, including an end surface of the adhesion layer 35. A portion of the second conductive layer 32 is also formed on the first conductive layer 31, and the second conductive layer 32 is electrically coupled to the first conductive layer 31. Likewise, another portion of the second conductive layer 32 is also formed on the fourth conductive layer 34, and the second conductive layer 32 is electrically coupled to the fourth conductive layer 34. In other words, the second conductive layer 32 is formed as bridge wiring that couples the first conductive layer 31 and the fourth conductive layer 34.

The second conductive layer 32 is formed by an electrolytic plating method or an electroless plating method. This forms the second conductive layer 32 selectively on an exposed surface of each of the first conductive layer 31, the fourth conductive layer 34, and the third conductive layer 33. Accordingly, in forming the second conductive layer 32, it is not necessary to use photolithography and etching technologies.

### [Workings and Effects]

For the conductive layer structure 3 and the light emitting device 1 according to the third embodiment, it is possible to obtain the same workings and effects as those obtained by the conductive layer structure 3 and the light emitting device 1 according to the first embodiment.

### <4. Fourth Embodiment>

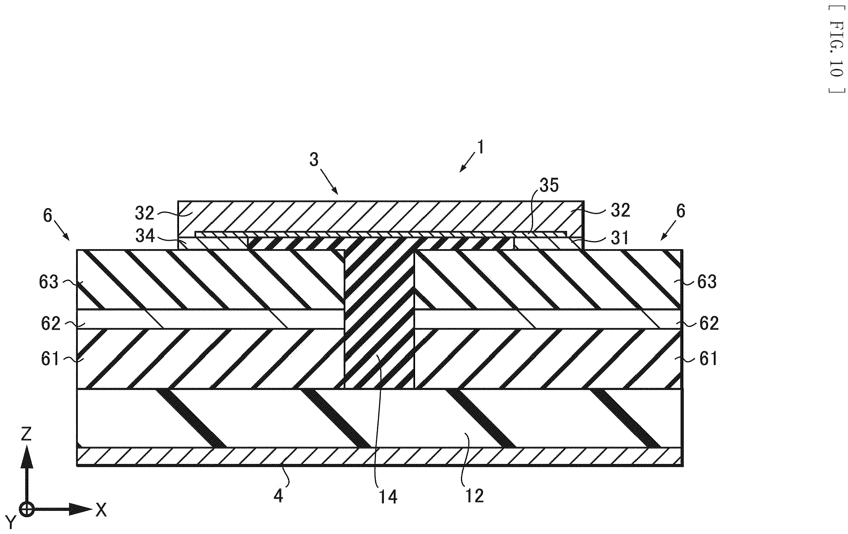

A conductive layer structure 3 and a light emitting device 1 according to a fourth embodiment of the present disclosure will be described with reference to FIG. 10.

### [Configuration of Conductive Layer Structure 3 and Light Emitting Device 1]

### (1) Overall Schematic Configuration of Conductive Layer Structure 3 and Light Emitting Device 1

FIG. 10 illustrates a longitudinal sectional configuration of an example of the conductive layer structure 3 and the light emitting device 1 according to a fourth embodiment of the present disclosure.

The light emitting device 1 according to the fourth embodiment includes a light emitting element 6. Furthermore, the light emitting device 1 includes the conductive layer structure 3.

The light emitting element 6 is laminated on a substrate 12 as a base in a region a lateral surface of which is surrounded by an insulator 14. In the fourth embodiment, the light emitting element 6 is a light emitting diode (LED). The light emitting element 6 includes a first semiconductor layer 61 of a first conductivity type, a light emitting layer 62, and a second semiconductor layer 63 of a second conductivity type each of which is sequentially laminated.

For the light emitting element 6, a plurality of light emitting elements 6 is arranged in each of the arrow X direction and the arrow Y direction with the insulator 14 interposed.

On the other hand, the conductive layer structure 3 includes a first conductive layer 31, a fourth conductive layer 34 that is formed with the insulator 14 interposed in the first conductive layer 31, and a second conductive layer 32 that is electrically coupled to each of the first conductive layer 31 and the fourth conductive layer 34 with the adhesion layer 35 interposed.

The first conductive layer 31, the adhesion layer 35, and the second conductive layer 32 are used as an electrode formed on the second semiconductor layer 63 of the light emitting element 6 on the right in the figure. The fourth conductive layer 34, the adhesion layer 35, and the second conductive layer 32 are used as an electrode formed on the second semiconductor layer 63 of the light emitting element 6 on the left in the figure. Here, the fourth conductive layer 34 is formed into the same electrode layer using the same material as the first conductive layer 31.

Then, the second conductive layer 32 is also configured as bridge wiring that couples the first conductive layer 31 and the fourth conductive layer 34.

Components other than the above are the same as those of the conductive layer structure 3 and the light emitting device 1 according to the first embodiment.

### [Workings and Effects]

In the conductive layer structure 3 and the light emitting device 1 according to the fourth embodiment, it is possible to obtain the same workings and effects as those obtained by the conductive layer structure 3 and the light emitting device 1 according to the first embodiment.

It is to be noted that in the conductive layer structure 3 and the light emitting device 1 according to the fourth embodiment, the conductive layer structure 3 according to the second embodiment or the third embodiment may be employed.

### <5. Other Embodiment>

The present technique is not limited to the above embodiments, and various modifications are possible within the scope not departing from the gist thereof.

For example, the above embodiments have described examples in which the present technique is applied to the conductive layer structure of a light emitting device, but the present technique is not limited to the light emitting device and is widely applicable to a semiconductor device such as an imaging device and a memory, a liquid crystal display, a wiring board or the like, and the conductive layer structure employed therein.

A conductive layer structure according to the first embodiment of the present disclosure includes a first conductive layer and a second conductive layer. The second conductive layer is electrically coupled to the first conductive layer with an adhesion layer interposed. The adhesion layer has conductivity and has a higher adhesiveness to each of the first conductive layer and the second conductive layer than adhesiveness between the first conductive layer and the second conductive layer. The second conductive layer is less likely to deteriorate than the adhesion layer, and covers an end surface and an upper surface of the adhesion layer while covering a portion of the first conductive layer.

Here, the adhesion layer is covered by the second conductive layer in a state where the adhesiveness between the first conductive layer and the second conductive layer is increased by the adhesion layer. In other words, even when exposed to a high temperature and high humidity environment, a route for oxygen or the like to enter the adhesion layer is blocked. This makes it possible to effectively suppress or prevent an increase in resistance of the current path due to a deterioration of the adhesion layer.

A conductive layer structure according to the second embodiment of the present disclosure includes a first conductive layer, a second conductive layer, and a third conductive layer. The third conductive layer is electrically coupled to the first conductive layer with an adhesion layer interposed. The second conductive layer is electrically coupled to the third conductive layer. The adhesion layer has conductivity and has a higher adhesiveness to each of the first conductive layer and the third conductive layer than adhesiveness between the first conductive layer and the third conductive layer. The second conductive layer is less likely to deteriorate than the adhesion layer, and covers an end surface and an upper surface of the adhesion layer while covering a portion of the first conductive layer.

Here, the adhesion layer is covered by the second conductive layer in a state where the adhesiveness between the first conductive layer and the third conductive layer is increased by the adhesion layer. In other words, even when exposed to a high temperature and high humidity environment, a route for oxygen or the like to enter the adhesion layer is blocked. This makes it possible to effectively suppress or prevent an increase in resistance of a current path due to a deterioration of the adhesion layer.

A conductive layer structure according to the third embodiment of the present disclosure includes a first conductive layer, a fourth conductive layer, and a second conductive layer. The fourth conductive layer is formed on the first conductive layer with an insulator interposed. The second conductive layer has one end coupled to the first conductive layer with an adhesion layer interposed, has a middle portion formed on the insulator, and has another end coupled to the fourth conductive layer with the adhesion layer interposed. The adhesion layer has conductivity and has a higher adhesiveness to each of the first conductive layer, the second conductive layer, and the fourth conductive layer than adhesiveness between the first conductive layer and the second conductive layer or adhesiveness between the fourth conductive layer and the second conductive layer. Then, the second conductive layer is less likely to deteriorate than the adhesion layer, and covers an end surface and an upper surface of the adhesion layer while covering a portion of the first conductive layer and a portion of the fourth conductive layer.

Here, the adhesion layer is covered by the second conductive layer in a state where the adhesiveness between the first conductive layer and the second conductive layer and the adhesiveness between the fourth conductive layer and the second conductive layer are increased by the adhesion layer. In other words, even when exposed to a high temperature and high humidity environment, a route for oxygen or the like to enter the adhesion layer is blocked. This makes it possible to effectively suppress or prevent an increase in resistance of a current path due to a deterioration of the adhesion layer.

A light emitting device according to the fourth embodiment of the present disclosure includes a light emitting element and a conductive layer structure that is formed in the light emitting element and supplies an electric current to the light emitting element. The conductive layer structure includes a first conductive layer and a second conductive layer. The second conductive layer is electrically coupled to the first conductive layer with an adhesion layer interposed. The adhesion layer has conductivity and has a higher adhesiveness to each of the first conductive layer and the second conductive layer than adhesiveness between the first conductive layer and the second conductive layer. The second conductive layer is less likely to deteriorate than the adhesion layer, and covers an end surface and an upper surface of the adhesion layer while covering a portion of the first conductive layer.

Here, the adhesion layer is covered by the second conductive layer in a state where the adhesiveness between the first conductive layer and the second conductive layer is increased by the adhesion layer. In other words, even when exposed to a high temperature and humidity environment, a route for oxygen or the like to enter the adhesion layer is blocked. This makes it possible to effectively suppress or prevent an increase in resistance of a current path due to a deterioration of the adhesion layer. Accordingly, in the light emitting device, the conductive layer structure has a small resistance, thus making it possible to effectively suppress or prevent an increase in drive voltage and a luminescence failure.

### <Configuration of the Present Technique>

The present technique includes the following configuration. According to the present technique having the following configuration, it is possible to provide a conductive layer structure and a light emitting device that make it possible to effectively suppress or prevent an increase in resistance of a current path due to an employment of an adhesion layer.
(1) A conductive layer structure, including:
   a first conductive layer; and
   a second conductive layer, the second conductive layer being electrically coupled to the first conductive layer with an adhesion layer interposed, in which
   the adhesion layer has conductivity, the adhesion layer having a higher adhesiveness to each of the first conductive layer and the second conductive layer than adhesiveness between the first conductive layer and the second conductive layer, and
   the second conductive layer is less likely to deteriorate than the adhesion layer, the second conductive layer covering an end surface and an upper surface of the adhesion layer while covering a portion of the first conductive layer.
(2) The conductive layer structure according to (1), in which the second conductive layer has a greater thickness than the adhesion layer.
(3) The conductive layer structure according to (1) or (2), in which
   the adhesion layer includes one or more materials selected from Ti, Ni, Al, Pd, Mg, Si, Cu, Ag, and TiW.
(4) The conductive layer structure according to any one of (1) to (3), in which
   the first conductive layer includes one or more materials selected from Au, Al, Cu, Ag, Rh, W, Mo, Ni, Pd, ITO, ITiO, ZnO, and AuGe.
(5) The conductive layer structure according to any one of (1) to (4), in which
   the second conductive layer is formed by electrolytic plating or electroless plating.
(6) The conductive layer structure according to any one of (1) to (5), in which
   the second conductive layer includes one or more materials selected from Au, Cu, Ni, Co, Sn, Pt, Ag, Pb, Zn, and Pd.
(7) The conductive layer structure according to any one of (1) to (6), in which
   the first conductive layer, the adhesion layer, and the second conductive layer configure a light emitting element.
(8) A conductive layer structure, including:
   a first conductive layer;
   a third conductive layer, the third conductive layer being electrically coupled to the first conductive layer with an adhesion layer interposed; and
   a second conductive layer, the second conductive layer being electrically coupled to the third conductive layer, in which
   the adhesion layer has conductivity, the adhesion layer having a higher adhesiveness to each of the first conductive layer and the third conductive layer than adhesiveness between the first conductive layer and the third conductive layer, and
   the second conductive layer is less likely to deteriorate than the adhesion layer, the second conductive layer covering an end surface and an upper surface of the adhesion layer while covering a portion of the first conductive layer.
(9) The conductive layer structure according to (8), in which
   the adhesion layer and the third conductive layer are formed in a same shape when viewed from a laminating direction thereof.
(10) The conductive layer structure according to (8) or (9), in which
   the second conductive layer is formed by electrolytic plating or electroless plating.
(11) A conductive layer structure, including:
   a first conductive layer;
   a fourth conductive layer, the fourth conductive layer being formed on the first conductive layer with an insulator interposed; and
   a second conductive layer, the second conductive layer having one end coupled to the first conductive layer with an adhesion layer interposed, a middle portion formed on the insulator, and another end formed with the adhesion layer interposed in the fourth conductive layer, in which
   the adhesion layer has conductivity, the adhesion layer having a higher adhesiveness to each of the first conductive layer, the second conductive layer, and the fourth conductive layer than adhesiveness between the first conductive layer and the second conductive layer or adhesiveness between the fourth conductive layer and the second conductive layer, and
   the second conductive layer is less likely to deteriorate than the adhesion layer, the second conductive layer covering an end surface and an upper surface of the adhesion layer while covering a portion of the first conductive layer and a portion of the fourth conductive layer.
(12) The conductive layer structure according to (11), in which
   the second conductive layer is formed by electrolytic plating or electroless plating.
(13) A light emitting device, including:
   a light emitting element; and
   a conductive layer structure, the conductive layer structure being coupled to the light emitting element and supplying an electric current to the light emitting element, in which the conductive layer structure includes
   a first conductive layer and
   a second conductive layer, the second conductive layer being electrically coupled to the first conductive layer with an adhesion layer interposed,
   the adhesion layer has conductivity, the adhesion layer having a higher adhesiveness to each of the first conductive layer and the second conductive layer than adhesiveness between the first conductive layer and the second conductive layer, and
   the second conductive layer is less likely to deteriorate than the adhesion layer, the second conductive layer covering an end surface and an upper surface of the adhesion layer while covering a portion of the first conductive layer.
(14) The light emitting device according to (13), in which
   the light emitting element includes a surface emitting laser or a light emitting diode.
(15) A method of forming a conductive layer structure, the method including:
   forming a first conductive layer;
   forming an adhesion layer on the first conductive layer; and
   forming a second conductive layer, the second conductive layer being electrically coupled to the first conductive layer with the adhesion layer interposed, in which
   the adhesion layer has conductivity, the adhesion layer having a higher adhesiveness to each of the first conductive layer and the second conductive layer than adhesiveness between the first conductive layer and the second conductive layer, and
   the second conductive layer includes a material less likely to deteriorate than the adhesion layer, the second conductive layer being formed by plating on an exposed surface of each of the first conductive layer and the adhesion layer.
(16) A method of forming a conductive layer structure, the method including:
   forming a first conductive layer;
   forming an adhesion layer on the first conductive layer;
   forming a second conductive layer, the second conductive layer being electrically coupled to the first conductive layer with the adhesion layer interposed; and
   forming a third conductive layer, the third conductive layer being electrically coupled to the second conductive layer, in which
   the adhesion layer has conductivity, the adhesion layer having a higher adhesiveness to each of the first conductive layer and the third conductive layer than adhesiveness between the first conductive layer and the third conductive layer, and
   the second conductive layer includes a material less likely to deteriorate than the adhesion layer, the second conductive layer being formed by plating on an exposed surface of each of the first conductive layer, the third conductive layer, and the adhesion layer.
(17) A method of forming a conductive layer structure, the method including:
   forming a first conductive layer;
   forming a fourth conductive layer, the fourth conductive layer being formed on the first conductive layer with an insulator interposed;
   forming an adhesion layer, the adhesion layer being formed on each of the first conductive layer and the fourth conductive layer; and
   forming a second conductive layer, the second conductive layer having one end electrically coupled to the first conductive layer with the adhesion layer interposed and having another end electrically coupled to the fourth conductive layer with the adhesion layer interposed, in which
   the adhesion layer has conductivity, the adhesion layer having a higher adhesiveness to each of the first conductive layer, the second conductive layer, and the fourth conductive layer than adhesiveness between the first conductive layer and the second conductive layer or adhesiveness between the fourth conductive layer and the second conductive layer, and
   the second conductive layer includes a material less likely to deteriorate than the adhesion layer, the second conductive layer being formed by plating on an exposed surface of the first conductive layer, the fourth conductive layer, and the adhesion layer.

In the method of manufacturing the conductive layer structure described in (15) to (17) above, the second conductive layer is formed by plating, thus resulting in a selective formation of the second conductive layer on a surface of the first conductive layer, the adhesion layer, and the like. This allows eliminating a process of forming a mask by photolithography technology and a patterning process by etching technology, thus making it possible to reduce the number of manufacturing processes in the method of manufacturing the conductive layer structure.

In addition, this allows reducing the number of manufacturing processes, thus making it possible to improve a manufacturing yield.

This application claims priority based on Japanese Patent Application No. 2021-130944 filed on August 10, 2021 with Japan Patent Office, the entire contents of which are incorporated in this application by reference.

It should be understood by those skilled in the art that various modifications, combinations, sub-combinations and alterations may occur depending on design requirements and other factors insofar as they are within the scope of the appended claims or the equivalents thereof.

## Claims

1. A conductive layer structure, comprising:
a first conductive layer; and
a second conductive layer, the second conductive layer being electrically coupled to the first conductive layer with an adhesion layer interposed, wherein
the adhesion layer has conductivity, the adhesion layer having a higher adhesiveness to each of the first conductive layer and the second conductive layer than adhesiveness between the first conductive layer and the second conductive layer, and
the second conductive layer is less likely to deteriorate than the adhesion layer, the second conductive layer covering an end surface and an upper surface of the adhesion layer while covering a portion of the first conductive layer.

2. The conductive layer structure according to claim 1, wherein
the second conductive layer has a greater thickness than the adhesion layer.

3. The conductive layer structure according to claim 1, wherein
the adhesion layer includes one or more materials selected from Ti, Ni, Al, Pd, Mg, Si, Cu, Ag, and TiW.

4. The conductive layer structure according to claim 1, wherein
the first conductive layer includes one or more materials selected from Au, Al, Cu, Ag, Rh, W, Mo, Ni, Pd, ITO, ITiO, ZnO, and AuGe.

5. The conductive layer structure according to claim 1, wherein
the second conductive layer is formed by electrolytic plating or electroless plating.

6. The conductive layer structure according to claim 5, wherein
the second conductive layer includes one or more materials selected from Au, Cu, Ni, Co, Sn, Pt, Ag, Pb, Zn, and Pd.

7. The conductive layer structure according to claim 1, wherein
the first conductive layer, the adhesion layer, and the second conductive layer configure a light emitting element.

8. A conductive layer structure, comprising:
a first conductive layer;
a third conductive layer, the third conductive layer being electrically coupled to the first conductive layer with an adhesion layer interposed; and
a second conductive layer, the second conductive layer being electrically coupled to the third conductive layer, wherein
the adhesion layer has conductivity, the adhesion layer having a higher adhesiveness to each of the first conductive layer and the third conductive layer than adhesiveness between the first conductive layer and the third conductive layer, and
the second conductive layer is less likely to deteriorate than the adhesion layer, the second conductive layer covering an end surface and an upper surface of the adhesion layer while covering a portion of the first conductive layer.

9. The conductive layer structure according to claim 8, wherein
the adhesion layer and the third conductive layer are formed in a same shape when viewed from a laminating direction thereof.

10. The conductive layer structure according to claim 8, wherein
the second conductive layer is formed by electrolytic plating or electroless plating.

11. A conductive layer structure, comprising:
a first conductive layer;
a fourth conductive layer, the fourth conductive layer being formed on the first conductive layer with an insulator interposed; and
a second conductive layer, the second conductive layer having one end coupled to the first conductive layer with an adhesion layer interposed, a middle portion formed on the insulator, and another end formed with the adhesion layer interposed in the fourth conductive layer, wherein
the adhesion layer has conductivity, the adhesion layer having a higher adhesiveness to each of the first conductive layer, the second conductive layer, and the fourth conductive layer than adhesiveness between the first conductive layer and the second conductive layer or adhesiveness between the fourth conductive layer and the second conductive layer, and
the second conductive layer is less likely to deteriorate than the adhesion layer, the second conductive layer covering an end surface and an upper surface of the adhesion layer while covering a portion of the first conductive layer and a portion of the fourth conductive layer.

12. The conductive layer structure according to claim 11, wherein
the second conductive layer is formed by electrolytic plating or electroless plating.

13. A light emitting device, comprising:
a light emitting element; and
a conductive layer structure, the conductive layer structure being coupled to the light emitting element and supplying an electric current to the light emitting element, wherein
the conductive layer structure includes
a first conductive layer and
a second conductive layer, the second conductive layer being electrically coupled to the first conductive layer with an adhesion layer interposed,
the adhesion layer has conductivity, the adhesion layer having a higher adhesiveness to each of the first conductive layer and the second conductive layer than adhesiveness between the first conductive layer and the second conductive layer, and
the second conductive layer is less likely to deteriorate than the adhesion layer, the second conductive layer covering an end surface and an upper surface of the adhesion layer while covering a portion of the first conductive layer.

14. The light emitting device according to claim 13, wherein
the light emitting element comprises a surface emitting laser or a light emitting diode.
